# EUROPÄISCHE PATENTSCHRIFT

(11) **EP 0 659 034 B1**
(45) Veröffentlichungstag und Bekanntmachung des Hinweises auf die Patenterteilung: **08.07.1998**
(21) Anmeldenummer: 94118449.1
(22) Anmeldetag: 24.11.1994
(51) Int. Cl.: H05B 37/02

(54) **Treppenlichtzeitschalter**
Timer for staircase lighting
Minuterie pour éclairage de cage d'escalier

(30) Priorität: 17.12.1993 DE 4343219
(43) Veröffentlichungstag der Anmeldung: 21.06.1995
(73) Patentinhaber: LEGRAND GmbH, D-59494 Soest (DE)
(72) Erfinder: Pelc, Peter, D-33181 Wünnenberg (DE)
(74) Vertreter: Hanewinkel, Lorenz, Dipl.-Phys.

(56) Entgegenhaltungen:
- CH-C- 658 340
- DE-A- 2 005 853
- FR-A- 2 335 937
- FR-A- 2 616 579

## Beschreibung

Die Erfindung betrifft ein Treppenlichtzeitschalter mit einer Wechselspannungsnetzspeisung, einer Sieb- und Gleichrichterschaltung, die einen Zeitgeberschaltkreis speist, deren Zeitgebersignal ein Schaltrelais schaltzeitbestimmend ansteuert, dessen Arbeitskontakt eine der Netzspannungsleitungen mit einer Treppenlichtspeiseleitung, die extern eine oder mehrere Treppenleuchten speist, brückt, und mit einer Tastersignalleitung, die extern mit einer oder mehreren Tastschaltern, jeweils betätigt, zu einer ersten der Netzsspannungsleitungen hin verbindbar ist, denen jeweils ggf. eine Reihenschaltung aus einer Glimmlampe und einem zugehörigen Vorwiderstand parallelgeschaltet ist, und wobei von der Tastersignalleitung jeweils bei einer Tastschalterbetätigung ein Startsignal dem Zeitgeberschaltkreis zugeführt ist, und zwischen der Tastersignalleitung und der jeweils zweiten der Netzspannungsleitungen eine Speiseschaltung der Glimmlampe(n) angeordnet ist.

Eine derartige Schaltung ist aus der DE 32 07 155 A1 vorbekannt. Dieser Treppenlichtautomat ist für die Installation von sogen. Drei- und Vierleiter-Treppenhausinstallationen vorgesehen und erbringt durch ein spezielles selbsthaltendes Impulsrelais eine Begrenzung der Strombelastung bei langdauernder Betätigung einer Treppenhaustaste oder bei einer Überlastung der Schaltung mit einer überhöhten Anzahl von Glimmlampen welche gewöhnlich parallel zu den Treppenhaustastern geschaltet sind. Die Impulsschaltung, welche das Relais steuert, weist eine gewisse Totzeit auf, die ein Nachtasten innerhalb eines bestimmten Zeitraumes nach dem Erlöschen des Treppenhauslichts verhindert.

Es ist Aufgabe der Erfindung einen Treppenlichtzeitschalter zu schaffen, der einfacher ist und ein beliebiges Nachtasten auch während der Brennzeit der Treppenhausbeleuchtung ermöglicht.

Die Lösung besteht darin, daß die Speiseschaltung aus einer Brückengleichrichterschaltung besteht, deren Gleichspannungsausgang mit einer elektronischen bistabilen Schaltung beschaltet ist, die immer dann in einen sehr hochohmigen Zustand geschaltet ist, wenn der über die Tastersignalleitung fließende Strom einen vorgegebenen Schwellwert überschreitet, und die ansonsten bis auf Durchlaßwiderstände von in diesem Stromweg befindlichen Halbleitern und Strombegrenzungswiderständen einen niederohmigen Stromweg bildet, und daß die Zeitgeberschaltung retriggerbar ist und über einen Optokoppler angesteuert ist, der eingangsseitig von dem Gleichspannungsausgang angesteuert ist.

Vorteilhafte Ausgestaltungen sind in den Unteransprüchen angegeben.

Die neuartige Schaltung erbringt rein elektronisch die Ansteuerung des nachtriggerbaren Zeitgeberschaltkreises und den Schaltungsschutz für die externe und interne Schaltung, und es kommt nur ein gewöhnliches Relais mit einem Arbeitskontakt zum Einsatz. Der Arbeitskontakt liegt in der Schaltstrecke der Treppenleuchten.

Vorzugsweise ist die bistabile Schaltung, welche bei Überschreitung eines Mindeststromes in der Taster- und Glimmlampenversorgungsleitung eingeschaltet ist, aus zwei Transistoren gebildet, von denen einer auf den Strom bezüglich des Schwellwertes durchschaltend reagiert und den nachsgeschalteten Transistor sperrt, so daß die Taster- und Glimmlampenleitung hochohmig, nur noch die Ansteuerungsschaltungen der beiden Transistoren ausreichend versorgend, leitend, mit der Netzspannung verbunden ist. Außerdem liegt jeweils die halbwellenmäßig schwankende Spannung vom Ausgang der Gleichrichterbrücke, der mit der bistabilen Schaltung beschaltet ist, über einen Stombegrenzungswiderstand und/oder ein RC-Netzwerk eingangsseitig an einem Optokoppler, der elektrisch isoliert von der Eingangsschaltung mit seiner Ausgangsschaltung über einen Verstärker das Zeitglied ansteuert, welches das Schaltrelais ensprechend seiner Schaltzeit betätigt.

Die strombegrenzende bistabile Schaltung ist über einen Doppelweggleichrichter gespeist, so daß praktisch zu jeder Halbwellenzeit im ersten Phasenabschnitt, wenn die Spannung noch gering ist und im Endphasenabschnitt, wenn die Spannung wieder gering ist, die Schaltung fast kurzgeschlossen leitend ist und jeweils nur bei einer Stromüberschreitung, wenn nämlich die Außenbeschaltung niederohmig ist und die Halbwellenspannung hoch genug ist, eine Abschaltung des Endschalttransistors erfolgt. Zum Schutz der Gleichrichterschaltung und der bistabilen Schaltung vor völliger Zerstörung bei netzseitigen Hochspannungsstoßspitzen und bei internen Kurzschlüssen. sind zweckmäßig Schutzwiderstände, die als Drahtwiderstände augebildet sind, in die Anschlußleitungen eingesetzt.

Es ist vorteilhaft vorgesehen, daß die Brückengleichrichterschaltung zwei Dioden und zwei Supressor-Zenerdioden enthält, wodurch auf einfache Weise eine Entstörung der Schaltung gegeben ist.

Es ist vorteilhaft vorgesehen, den Schalttransistor sourceseitig gegenkoppelnd in Reihe mit einer Induktivität zu schalten, welche als Hochfrequenz-Entstördrossel dient und das Auftreten von hochfrequenten Schaltstromspitzen verhindert. Zum Schutz des Schalttransistors ist außerdem eine Abfangdiode zur Begrenzung der Gate-Spannung an der Steuerektrode vorgesehen, die andererseits zu dem Anschlußpunkt der Entstördrossel an dem Schalttransistor geführt ist.

Die gesamte Schaltung verbraucht außerordentlich wenig Leistung, insbesondere wenn der Schalttransistor als MOSFET-Transistor ausgeführt ist. Dies erlaubt einen Aufbau der gesamten Treppenhausautomatenschaltung in einer Oberflächenmontagetechnik, der sogen. SMD-Technik. Hierdurch ermöglicht sich deren Unterbringung in einem Gehäuse, welches nur eine Standardbreite von 17,5 mm in der Standardmodultechnik aufweist.

Die neuartige Schaltung ist völlig "kurzschlußfest", d.h. sie verbraucht auch dann, wenn ein Taster im Ein-Zustand blockiert ist oder wenn zu hoher Glimmlampenstrom fließt, keine unzulässig hohe Leistung. Die Schaltung ist auch mit einem Dauereinschalter problemlos bestückbar.

Die Schaltung ist für eine große Zahl von Glimmlampen einsetzbar, wobei unter Umständen ihre Empfindlichkeit durch eine geeignete Auswahl der Spannungsteilerwiderstände, welche die Schaltschwelle bestimmen, an die Anzahl der Lampen anpaßbar ist, wenn eine hohe Empfindlichkeit bei abweichendem Glimmlampenstrom gewünscht ist.

Die gezeigte bistabile Schaltung, die auf einen Überstrom abschaltend, d. h. hochohmigschaltend, reagiert, jedoch bei einer Rückkehr zu Strömen unter der gesetzten Schwelle, d. h. bei ausreichendem Widerstand im externen Zweig, wieder voll durchschaltet, läßt sich auch in anderen Anwendungsbereichen vorteilhaft einsetzen.

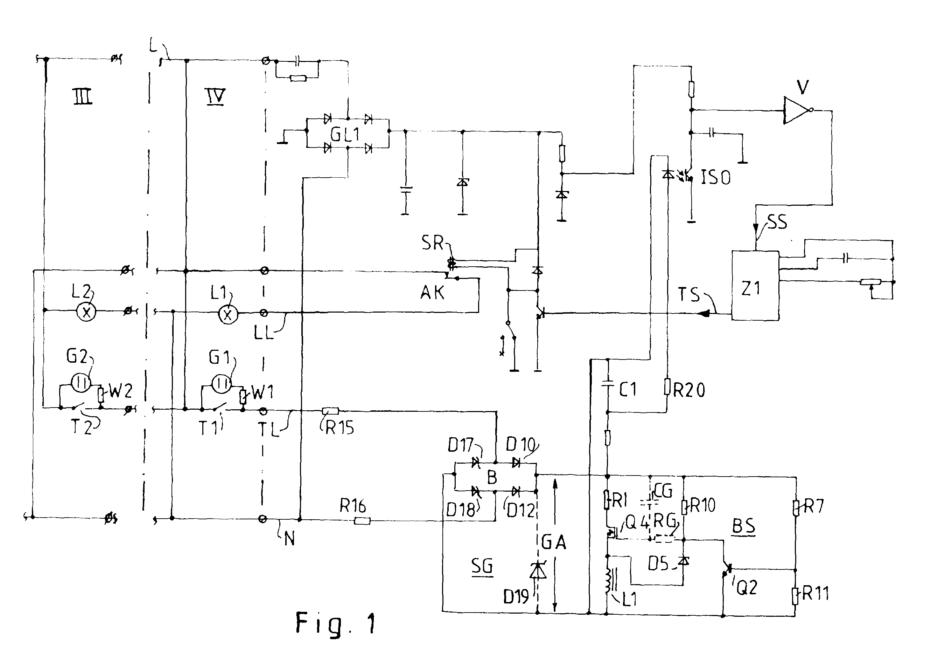

Eine vorteilhafte Ausgestaltung ist in der Figur 1 dargestellt.

Im linken Bildteil ist eine sogenannte Dreileiterinstallation (III) dargestellt, bei der an die Netzleitung der einen Art jeweils die Leuchten (L2) und die Glimmlampe (G2) mit dem Vorwiderstand (W2) und parallel dazu ein Treppenhaustaster (T2) geschaltet sind und die andere Netzzuleitung dem Relaiskontakt (AK) des Treppenhausschaltrelais (SR) zugeführt ist, welcher andererseits auf die Treppenhauslichtspeiseleitung (LL) der Treppenhausleuchte (L2) führt.

Der zweite Abschnitt von links im Bild, zeigt eine sogen. Vierleiterinstallation (IV), bei der die Treppenhausleuchte (L1) an der zweiten Versorgungsspannungleitung (N) angeschlossen ist und die Glimmlampe (G1) mit dem Vorwiderstand (D1) und parallel dazu der Treppenhaustaster (T1) an der ersten Versorgungsleitung (L) angeschlossen sind. Auch hier führt jeweils die andere Versorgungsspannungsleitung (L) zu dem Relaiskontakt (AK) des Treppenhausrelais (SR), dessen andere Seite zur Treppenlichtspeiseleitung (LL) wie im ersten Fall führt.

Von den Tastschaltern (T1, T2) führt die Tastsignalleitung (TL) zu einer Glimmlampenspeiseschaltung (SG), die eine bistabile Schaltung (BS) umfaßt, die eine über eine Brückenschaltung (B) gespeist ist, welche entweder aus zwei Gleichrichterdioden (D10, D12) einerseits und zwei Supressor-Zenerdioden (D17, D18) andererseits besteht, oder eine mit einer Supopressor-Zenerdiode (D19) ausgangsseitig beschaltete gewöhnliche Diodenbrücke ist. Eine doppelweggleichgerichtete Spannung liegt an den Brückengleichrichterausgängen (GA), die mit der Schaltstrecke eines ersten Schalttransistor (Q4) beschaltet sind, der ein Hochspannungs-MOSFET-Transistor ist. Es ist lediglich eine insbesondere dynamisch gegenkoppelnde Entstördrossel (L1) in den Schaltweg dieses Transistors (Q4), der eingeschaltet einen Innenwiderstand (RI) aufweist, sourceseitig eingefügt oder äquivalentes kapazitives Gegenkoppelglied (RG, CG) gateseitig eingefügt ist, das gestrichelt dargestellt ist. Die Gateelektrode dieses ersten Schalttansistors (Q4) ist aufsteuernd mit einem Widerstand (R10) und mit einer Abfangzenerdiode (D5) beschaltet. Außerdem liegt an der Gateektrode die Schaltstrecke eines zweiten Transistors (Q2), der eingangsseitig mit einem Spannungsteiler (R7, R11) beschaltet ist, welcher über den Ausgang der Brückenschaltung (B) gelegt ist. Auf diese Weise wird der Strom der Brücke (B) über diesen Spannungsteiler (R7, R11) geleitet, und es wird dann, wenn der Strom durch eine externe Niederohmschaltung eine so bestimmte Grenze überschreitet, die Basisspannung des zweiten Schalttransistors (Q2) überschritten, so daß dieser den ersten Schalttransistor (Q4) sperrt und die Schaltung hochohmig wird. Dieser Fall tritt immer dann ein, wenn ein Treppenlichtaster (T1, T2) geschlossen ist oder eine der Glimmlampenstrecken zuviel Strom führt. Die dadurch auftretende hohe Spannung am Ausgang der Brückenschaltung speist den Optokoppler (ISO) über einen strombegrenzenden Widerstand (R12), ggf. über ein RC-Glied (R20, C1) entstört, so daß der Optokoppler (ISO) über einen nachgeschalteten Verstärker (V), vorzugsweise einen Schmitt-Trigger, ein Startsignal (SS) an einen Zeitgeberschaltkreis (Z1) abgibt. Das dadurch auftretende Zeitgebersignal (TS) ist von dem Zeitgeberschaltkreis (Z1) über einen Verstärkertransistor auf das Treppenhausschaltrelais (SR) geführt, daß dadurch den Arbeitskontakt (AK) betätigt und die Treppenhausleuchten (L1, L2) versorgt.

Die Zeitgeberschaltung einschließlich des nachgeschalteten Relais (SR) ist über eine Sieb- und Gleichrichterschaltung (GL1) mit einer Niedervoltgleichspannung versorgt. Diese gesamte Schaltung ist durch den Optokoppler (ISO) von der bistabilen Schaltung (BS) elektrisch vollständig isoliert, so daß irgendwelche Fehlschaltungen beim Instalieren von den Treppenhausleuchten oder -tastern zu keinen Schäden an den Schaltungen führen können. Der retriggerbare Zeitgeberschaltkreis (Z1) ist in bekannter Weise mit einem Zeitglied beschaltet, das vorzugsweise mit einem Potentiometer bestückt ist, so daß die Einschaltdauer der Treppenleuchten (L1, L2) bedarfsgemäß einstellbar ist.

In den Zuleitungen der Brückengleichrichterschaltung (B) sind jeweils spitzenstrombegrenzende Schutzwiderstände (R15, R16) eingeschaltet, die zweckmäßig als Drahtwiderstände ausgebildet sind und dadurch eine Sicherungsfunktion übernehmen, falls die bistabile Schaltung oder die Brückenschaltung (B) durch einen Kurzschluß ausfallen sollten, und eine Überstromschutzfunktion haben, wenn Hochspannungsstörspitzen netzseitig auftreten.

## Patentansprüche

1. Treppenlichtzeitschalter mit einer Wechselspannungsnetzspeisung, einer Sieb- und Gleichrichterschaltung (GL1), die einen Zeitgeberschaltkreis (Z1) speist, deren Zeitgebersignal (TS) ein Schaltrelais (SR) schaltzeitbestimmend ansteuert, dessen Arbeitskontakt (AK) eine der Netzspannungsleitungen (N, L) mit einer Treppenlichtspeiseleitung (LL), die extern eine oder mehrere Treppenleuchten (L1, L2) speist, brückt, und mit einer Tastersignalleitung (TL), die extern mit einer oder mehreren Tastschaltern (T1, T2), jeweils betätigt, zu einer ersten der Netzsspannungsleitungen (N, L) hin verbindbar ist, denen jeweils ggf. eine Reihenschaltung aus einer Glimmlampe (G1, G2) und einem zugehörigen Vorwiderstand (W1, W2) parallelgeschaltet ist, und wobei von der Tastersignalleitung (TL) jeweils bei einer Tastschalterbetätigung ein Startsignal (SS) dem Zeitgeberschaltkreis (Z1) zugeführt ist, und zwischen der Tastersignalleitung (TL) und der jeweils zweiten der Netzspannungsleitungen (L, N) eine Speiseschaltung (SG) der Glimmlampe(n) (G1, G2) angeordnet ist, dadurch gekennzeichnet, daß die Speiseschaltung (SG) aus einer Brückengleichrichterschaltung (B) besteht, deren Gleichspannungsausgang (GA) mit einer elektronischen bistabilen Schaltung (BS) beschaltet ist, die immer dann in einen sehr hochohmigen Zustand geschaltet ist, wenn der über die Tastersignalleitung (TL) fließende Strom einen vorgegebenen Schwellwert überschreitet, und die ansonsten bis auf Durchlaßwiderstände von in diesem Stromweg befindlichen Halbleitern und Strombegrenzungswiderständen (R15, R16) einen niederohmigen Stromweg bildet, und daß die Zeitgeberschaltung (Z1) retriggerbar ist und über einen Optokoppler (ISO) angesteuert ist, der eingangsseitig von dem Gleichspannungsausgang (GA) angesteuert ist.

2. Treppenlichtzeitschalter nach Anspruch 1, dadurch gekennzeichnet, daß die Speiseschaltung (SG) aus einem netzspannungsfesten ersten Schalttransistor (Q4) besteht, dessen Schaltstrecke über die Brückengleichrichterausgänge (GA) geschaltet ist und dessen Steuerelektrode durch einen aufsteuernden Widerstand (R10) mit einer Abfangzenerdiode (D5) und mit einer Schaltstrecke eines zweiten Transistors (Q2) beschaltet ist, dessen Basis mit einem Spannungsteiler (R7, R11) beschaltet ist, der zwischen den Brückengleichrichterausgängen (GA) liegt und dessen Teilerverhältnis in Verbindung mit der Basis-Emitterspannung des zweiten Transistors (Q2) den vorgegebenen Schwellwert bestimmt, oberhalb dessen jeweils der zweite Transistor (Q2) eingeschaltet und der erste Schalttransistor (Q4) gesperrt gesteuert ist.

3. Treppenlichtzeitschalter nach Anspruch 1 oder 2, dadurch gekennzeichnet, daß die Strombegrenzungswiderstände (R15, R16) in den wechselspannungsseitigen Zuleitungen zu der Brückengleichrichterschaltung (B) angeordnet sind und als Drahtwiderstände ausgebildet sind.

4. Treppenlichtzeitschalter nach einem der vorstehenden Ansprüche, dadurch gekennzeichnet, daß die Brückengleichrichterschaltung (B) ausgangsseitig mit mindestens einer Suppressor-Zenerdiode (D17, D18; D19) stabilisierend beschaltet ist.

5. Treppenlichtzeitschalter nach einem der vorstehenden Ansprüche, dadurch gekennzeichnet, daß der erste Schalttransistor (Q4) ein MOSFET-Transistor ist.

6. Treppenlichtzeitschalter nach einem der vorstehenden Ansprüche, dadurch gekennzeichnet, daß der erste Schalttransistor (Q4) dynamisch gegengekoppelt ist.

7. Treppenlichtzeitschalter nach Anspruch 6, dadurch gekennzeichnet, daß der Emitter- oder Sourceanschluß des ersten Schalttransistors (Q4) sowie ggf. die Abfangzenerdiode (D5) über eine entstörend gekoppelnde Hochfrequenzdrossel (L1) versorgungsseitig angeschlossen sind.

8. Treppenlichtzeitschalter nach einem der vorstehenden Ansprüche, dadurch gekennzeichnet, daß von den Gleichsspannungsanschlüssen (GA) die Brückengleichrichterschaltung (B) über einen Vorwiderstand (R12) und ggf. ein Entstörglied (C1, R20) eine Leuchtdiodenstrecke eines Optokopplers (ISO) angesteuert ist, dessen Ausgangssignal als das Startsignal (SS) dem Zeitgeberschaltkreis (Z1) zugeführt ist.

9. Treppenlichtzeitschalter nach einem der vorstehenden Ansprüche, dadurch gekennzeichnet, daß ihre Bauelemente in Oberflächenmontagetechnik (SMD-Technik) auf einem Schaltungsträger angeordnet sind und dieser in einem Gehäuse mit einer einzigen Standardmodulbreite von 17,5 mm angeordnet ist.

## Claims

1. Stairwell light timer having an a.c. voltage mains supply, a filter and rectifier circuit (GL1) which supplies a timing circuit (Z1) of which the timing signal (TS) is activated by a switching relay (SR) in a manner determining the switch-over time, and the contact element (AK) of said switching relay (SR) bridges one of the mains voltage lines (N, L) with a stairwell light supply line (LL) which externally supplies one or more stairwell lamps (L1, L2), and having a momentary-contact signal line (TL) which is adapted to be connected externally by one or more momentary-contact switches (T1, T2), respectively actuated, to a first of the mains voltage lines (N, L), with which lines, if appropriate, a series connection consisting of a glow-discharge lamp (G1, G2) and an associated series resistor (W1, W2) is connected in parallel in each case, and a start signal (SS) being sent from the momentary-contact signal line (TL) to the timing circuit (Z1) each time the momentary-contact switch is actuated, and between the momentary-contact signal line (TL) and the respective second of the mains supply lines (L, N) there is arranged a feeder circuit (SG) for the glow-discharge lamp(s) (G1, G2),
characterised in that the feeder circuit (SG) consists of a bridge-connected rectifier circuit (B) of which the d.c. voltage output (GA) is wired to an electronic bistable circuit (BS) which is connected in a very highly resistive state whenever the current flowing via the momentary-contact signal line (TL) exceeds a preset threshold value, and which otherwise forms a low-impedance current path except for forward resistances of semi-conductors and current limiting resistors (R15, R16) situated in the current path, and that the timing circuit (Z1) is retriggerable and is activated via an optical isolator (ISO) which is activated on the input side from the d.c. voltage output (GA).

2. Stairwell light timer according to claim 1, characterised in that the feeder circuit (SG) consists of a fixed mains-voltage first switching transistor (Q4) of which the contact gap is connected via the bridge-connected rectifier outputs (GA) and of which the control electrode is wired through a progressive-type resistor (R10) to an intercepting Zener diode (D5) and to a contact gap of a second transistor (Q2), the base of which is wired to a voltage divider (R7, R11) which is situated between the bridge-connected rectifier outputs (GA) and of which the divider ratio in conjunction with the base-emitter voltage of the second transistor (Q2) determines the preset threshold value above which the second transistor (Q2) is in each case brought into circuit and the first switching transistor (Q4) is inhibited.

3. Stairwell light timer according to claim 1 or 2, characterised in that the current limiting resistors (R15, R16) are arranged in the incoming cables on the a.c. voltage side running to the bridge-connected rectifier circuit (B) and are in the form of wire-wound resistors.

4. Stairwell light timer according to any of the preceding claims, characterised in that on the output side the bridge-connected rectifier circuit (B) is wired to at least one suppressor Zener diode (D17, D18; D19) with stabilising effect.

5. Stairwell light timer according to any of the preceding claims, characterised in that the first switching transistor (Q4) is a MOSFET transistor.

6. Stairwell light timer according to any of the preceding claims, characterised in that the first switching transistor (Q4) is dynamically degenerative.

7. Stairwell light timer according to claim 6, characterised in that the emitter terminal or source terminal of the first switching transistor (Q4) and, if appropriate, the intercepting Zener diode (D5) are linked on the supply side via an interference-suppression degenerative radio-frequency choke (L1).

8. Stairwell light timer according to any of the preceding claims, characterised in that from the d.c. voltage terminals (GA) the bridge-connected rectifier circuit (B) is activated via a series resistor (R12) and, if appropriate, an interference-suppression element (C1, R20) via a light-emitting diode path of an optical isolator (ISO), the output signal of which is sent as the start signal (SS) to the timing circuit (Z1).

9. Stairwell light timer according to any of the preceding claims, characterised by the fact that its components are surface-mounted (surface mount technology; SMT) on a circuit mount and the latter is arranged in an enclosure having a single standard module width of 17.5 mm.

## Revendications

1. Minuterie pour éclairage de cage d'escalier comprenant une alimentation par le réseau à courant alternatif, un circuit de filtrage et de redressement (GL1) qui alimente un circuit d'horloge (Z1) dont le signal (TS) excite un relais de commutation (SR) en déterminant le temps de commutation, le contact de travail (AK) de ce relais pontant l'une des conduites de tension de réseau (N, L) avec une conduite d'alimentation (LL) de l'éclairage de la cage d'escalier qui dessert externement une ou plusieurs lampes témoins (L1, L2), et avec une conduite d'acheminement de signaux (TL) qui peut être raccordée externement à la première des conduites de tension de réseau (N, L) par un ou plusieurs boutons de touche (T1, T2), actionnés respectivement, un circuit série comprenant une lampe fluorescente (G1, G2) et une résistance additionnelle afférente (W1, W2) étant, le cas échéant, connectée en parallèle sur les conduites de tension de réseau et un signal de départ (SS) étant lancé par la conduite d'acheminement de signaux au circuit d'horloge (TL) lors de chaque actionnement d'un bouton de touche, et un circuit d'alimentation (SG) de la/des lampe/s fluorescente/s (G1, G2) étant installé entre la conduite d'acheminement de signaux (TL) et la deuxième des conduites de tension de réseau (L, N) respective,
caractérisée en ce que
le circuit d'alimentation (SG) consiste en un circuit redresseur à pont (B) dont la sortie de tension continue (GA) est filée avec un circuit électronique bistable (BS) qui est toujours connecté à un état à valeur ohmique très élevée quand le courant circulant par la conduite d'acheminement de signaux (TL) dépasse une valeur de seuil prédéterminée et sinon forme un parcours de courant de faible valeur ohmique, part faite des résistances de passage des semi-conducteurs et des résistances limiteuses de courant présents dans ce parcours de courant, le circuit d'horloge (Z1) étant redéclenchable et excité par l'intermédiaire d'un coupleur opto-électronique (ISO) qui est excité côté entrée par la sortie de tension continue (GA).

2. Minuterie selon la revendication 1,
caractérisée en ce que
le circuit d'alimentation (SG) est composé d'un premier transistor (Q4) Netzspannungsfest dont le parcours de commutation est mis en circuit par l'intermédiaire des sortie du redresseur à pont (GA) et dont l'électrode de commande est filée avec une diode Zener de captage (D5) et un autre parcours de commutation d'un deuxième transistor (Q2) par une résistance (R10), la base de ce deuxième transistor (Q2) étant filée avec un diviseur de tension (R7, R11) situé entre les sorties /GA) du redresseur à pont et dont le rapport de division en relation avec la tension émetteur de base du deuxième transistor (Q2) détermine la valeur de seuil au-dessus de laquelle le deuxième transistor (Q2) est mis en circuit et le premier transistor de commutation (Q4) hors de circuit.

3. Minuterie selon la revendication 1 ou 2,
caractérisée
en ce que
les résistances limiteuses de courant (R15, R16) sont disposées dans les conduites d'amenée côté tension alternative à destination du circuit redresseur à pont (B) et conçues sous forme de résistances en fil métallique.

4. Minuterie selon l'une des revendications précédentes,
caractérisée en ce que
le circuit redresseur à pont (B) est filé, stabilisant, avec au moins une diode Zener suppressor (D17, D18; D19), côté sortie.

5. Minuterie selon l'une de revendications précédentes,
caractérisée en ce que
le premier transistor de commutation (Q4) est un transistor M.O.S.FET.

6. Minuterie selon l'une des revendications précédentes,
caractérisée en ce que
le premier transistor de commutation (Q4) est contre-couplé dynamiquement.

7. Minuterie selon la revendication 6,
caractérisée en ce que
le raccord émetteur ou source du premier transistor (Q4) et, le cas échéant, la diode Zener de captage (D5) sont raccordés côté alimentation par l'intermédiaire d'une inductance antiparasite à haute fréquence (L1).

8. Minuterie selon l'une des revendications précédentes,
caractérisée en ce que
le circuit redresseur à pont (B) est excité, des raccords de tension continue (GA) par l'intermédiaire d'une résistance additionnelle (R12) et, le cas échéant, d'un élément antiparasite (C1, R20) est excité sur un parcours de diodes électroluminescentes d'un coupleur opto-électronique (ISO) dont le signal est conduit, en tant que signal de départ (SS), au circuit de commutation d'horloge (Z1).

9. Minuterie selon l'une des revendications précédentes,
caractérisée en ce que
ses éléments de construction selon la technique de montage dite SMD sont disposés sur un support et que celui-ci est logé dans un boîtier d'une seule largeur modulaire standard de 17,5 mm.
